(19) Europäisches Patentamt
European Patent Office
Office européen des brevets

(11) **EP 4 344 060 A1**

(12) **EUROPEAN PATENT APPLICATION**

(43) Date of publication:
**27.03.2024   Bulletin 2024/13**

(21) Application number: **22196939.7**

(22) Date of filing: **21.09.2022**

(51) International Patent Classification (IPC):
**H03H 7/25** (2006.01)     **H03H 7/46** (2006.01)
**H01P 1/22** (2006.01)     **H04B 1/44** (2006.01)

(52) Cooperative Patent Classification (CPC):
**H03H 7/465; H03H 7/25; H04B 1/44; H01P 5/12**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **NXP B.V.**
**5656 AG Eindhoven (NL)**

(72) Inventors:
• **Yang, Xin**
**Eindhoven (NL)**
• **Acar, Mustafa**
**Eindhoven (NL)**

• **Chen, Zhe**
**Eindhoven (NL)**
• **Leenaerts, Dominicus Martinus Wilhelmus**
**Eindhoven (NL)**

(74) Representative: **Miles, John Richard**
**NXP SEMICONDUCTORS**
**Intellectual Property Group**
**Abbey House**
**25 Clarendon Road**
**Redhill, Surrey RH1 1QZ (GB)**

Remarks:
Amended claims in accordance with Rule 137(2) EPC.

(54) **DIGITAL, INDUCTIVE STEP ATTENUATOR WITH CAPACITIVE PHASE-GAIN COMPENSATION AND INCORPORATION INTO QUARTER-WAVE TX / RX SWITCH**

(57)    An attenuator circuit (100) comprising: a digital attenuator part (101) comprising: a first (102) and second attenuator terminal (103); a first inductor (104) having a first terminal coupled to the first attenuator terminal and a second terminal coupled to the second attenuator terminal; a first switched arrangement comprising a first switch (110) having a first switch-terminal and a second switch-terminal, wherein the first switch-terminal is coupled to the first terminal of the first inductor, and a first resistor (111) and a first capacitor (112) are arranged in parallel, coupled between the second switch-terminal and a reference voltage; and a second switched arrangement comprising a second switch (114) having a first switch-terminal and a second switch-terminal, wherein the first switch-terminal is coupled to the second terminal of the first inductor, and wherein a second resistor (115) and a second capacitor (116) are arranged in parallel and coupled between the second switch-terminal and the reference voltage. The first and second capacitors are for compensation different capacitive load due to switching on and off of first and second switches to thereby reduce gain-phase variations in different attenuation states.

Figure 1

# Description

## Field

The present disclosure relates to a circuit comprising an attenuation part for providing selective attenuation. It also relates to a circuit comprising the attenuation part integrated with a switch part.

## Background

An attenuator provides for attenuation of a signal. In one or more examples, the attenuator may be configured to include one or more switches such that the attenuation may be selectively provided. An example measure of the performance of an attenuator is the gain-to-phase error. The use of the one or more switches may negatively impact the gain-to-phase error.

## Summary

According to a first aspect of the present disclosure there is provided a circuit comprising:
a digital attenuator part comprising:

> a first attenuator terminal;
> a second attenuator terminal;
> a first inductor having a first terminal coupled to the first attenuator terminal and a second terminal coupled to the second attenuator terminal;
> a first switched arrangement comprising a first switch having a first switch-terminal and a second switch-terminal, wherein the first switch-terminal is coupled to the first terminal of the first inductor, and wherein a first resistor and a first capacitor are arranged in parallel and coupled between the second switch-terminal and a reference terminal, the reference terminal configured to be coupled to a reference voltage;
> a second switched arrangement comprising a second switch having a first switch-terminal and a second switch-terminal, wherein the first switch-terminal is coupled to the second terminal of the first inductor, and wherein a second resistor and a second capacitor are arranged in parallel and coupled between the second switch-terminal and the reference terminal.

In one or more embodiments, the first inductor comprises or is configured as a quarter-wave impedance transformer and may be embodied as one of:

> a quarter wavelength transmission line; and
> a pi-network.

In one or more embodiments, one or both of:

> the first resistor has the same resistance as the second resistor; and

the first capacitor has the same capacitance as the second capacitor.

In one or more embodiments, the digital step attenuator part is configured to provide:

> an attenuation mode in which both the first switch and the second switch are closed to thereby provide attenuation of a signal input to the first attenuator terminal and output at the second attenuator terminal; and
> a bypass mode in which both the first switch and the second switch are open.

In one or more embodiments, the capacitance of one or both of the first capacitor and the second capacitor is greater than the off-state capacitance of one or the both the first switch and the second switch.

In one or more embodiments, the circuit comprises a plurality of said digital attenuator parts coupled together in series by their first and second attenuator terminals to provide a multi-bit digital step attenuator.

In one or more embodiments, the circuit comprises a plurality of said digital attenuator parts and further comprising a switch part, the switch part comprising:

> a common terminal, a first switch-part terminal and a second switch-part terminal, wherein the switch part is switchable at least between providing a path for a signal between the common terminal and the first switch-part terminal and providing a path for a signal between the common terminal and the second switch-part terminal; wherein
> a first digital attenuator part of said plurality of digital attenuator parts is configured with its first attenuator terminal connected to the common terminal and its second attenuator terminal connected to the first switch-part terminal; and
> a second digital attenuator part of said plurality of digital attenuator parts is configured with its first attenuator terminal connected to the common terminal and its second attenuator terminal connected to the second switch-part terminal; and wherein
> each of the plurality of said digital attenuator parts are configured to provide an attenuation mode in which both the first switch and the second switch of the respective attenuator part are closed to thereby provide attenuation of a signal and a bypass mode in which both the first switch and the second switch of the respective attenuator part are open.

In one or more embodiments, the switch part comprises a third switch coupled to the first switch-part terminal and configured to provide a switched connection to the ground terminal; and the switch part comprises a fourth switch coupled to the second switch-part terminal and configured to provide a switched connection to the ground terminal.

In one or more embodiments, the first and second digital attenuator parts and the switch part in combination are configured to provide four modes, wherein the modes comprise:

a first-attenuator-terminal-with-attenuation mode in which the third switch is off, the fourth switch is on and the second switch of the second digital attenuator part is on to provide the path for the signal between the common terminal and the first switch-part terminal, and wherein the first switch and the second switch of the first digital attenuator part is on to provide the attenuation;

a first-attenuator-terminal-without-attenuation mode in which the third switch is off, the fourth switch is on and the second switch of the second digital attenuator part is on to provide the path for the signal between the common terminal and the first switch-part terminal, and wherein the first switch and the second switch of the first digital attenuator part is off to not provide the attenuation;

a second-attenuator-terminal-with-attenuation mode in which the third switch is on, the fourth switch is off and the second switch of the first digital attenuator part is on to provide the path for the signal between the common terminal and the second switch-part terminal, and wherein the first switch and the second switch of the second digital attenuator part is on to provide the attenuation;

a second-attenuator-terminal-without-attenuation mode in which the third switch is on, the fourth switch is off and the second switch of the first digital attenuator part is on to provide the path for the signal between the common terminal and the second switch-part terminal, and wherein the first switch and the second switch of the second digital attenuator part is off to not provide the attenuation.

In one or more embodiments, the first switched arrangement of the first digital attenuator part and the first switched arrangement of the second digital attenuator part comprise a shared first switched arrangement for both the first digital attenuator part and the second digital attenuator part.

In one or more embodiments, the switch part includes a first branch between the shared first switched arrangement and the first inductor of the first digital attenuator part and a second branch between the shared first switched arrangement and the first inductor of the second digital attenuator part.

In one or more embodiments, at least one of the first inductor of the first digital attenuator part and the first inductor of the second digital attenuator part comprise a quarter wavelength transmission line.

In one or more embodiments, at least one of the first inductor of the first digital attenuator part and the first inductor of the second digital attenuator part comprise part of a pi-network arrangement.

In one or more embodiments, said first switch-part terminal is coupled to a transmit path wherein the switch part is configured to switchably couple the common terminal to the first switch-part terminal to enable a signal provided at the common terminal to be transmitted; and said second switch-part terminal is coupled to a receive path wherein the switch part is configured to switchably couple the common terminal to the second switch-part terminal to enable a signal to be received from the receive path and passed to the common terminal.

In one or more embodiments, the plurality of said digital attenuator parts and the switch part collectively provide a quarter wave TX/RX switch having selectively provided attenuation.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

**Brief Description of the Drawings**

One or more embodiments will now be described by way of example only with reference to the accompanying drawings in which:

Figure 1 shows an example embodiment of a circuit comprising an attenuator part;

Figure 2 shows the effective circuit of figure 1 when the switches of the attenuator part are off (i.e. open);

Figure 3 shows the effective circuit of figure 1 when the switches of the attenuator part are on (i.e. closed);

Figure 4 shows a graph of gain-to-phase error versus frequency of a signal provided to an attenuator;

Figure 5 shows a graph of gain-to-phase error versus frequency of a signal provided to the attenuator part of figure 1;

Figure 6 shows an example front end module of a transmitter/receiver, which may comprise an analog beamformer;

Figure 7 shows a first example embodiment of a circuit including the attenuator part integrated with a switch part;

Figure 8 shows a second example embodiment of a circuit including the attenuator part integrated with a switch part; and

Figure 9 shows a third example embodiment of a circuit including the attenuator part integrated with a switch part.

## Detailed Description

An attenuator is configured to receive a signal at its input, reduce the power of the signal and provide the reduced-power signal at its output. In one or more examples, the attenuation provided by an attenuator may be selectively provided. Thus, in one or more examples, the attenuator may include one or more switches to connect and/or disconnect one or more components in a circuit to selectively provide the attenuation. In one or more examples, the attenuator may include one or more resistive and/or capacitive components that are tuneable to provide for control of the level of attenuation provided by the attenuator.

An example measure of the performance of an attenuator is the gain-to-phase error. The use of the one or more switches may negatively impact the gain-to-phase error. One or more example embodiments herein may provide an attenuator configured to selectively provide attenuation with advantageous gain-to-phase error performance.

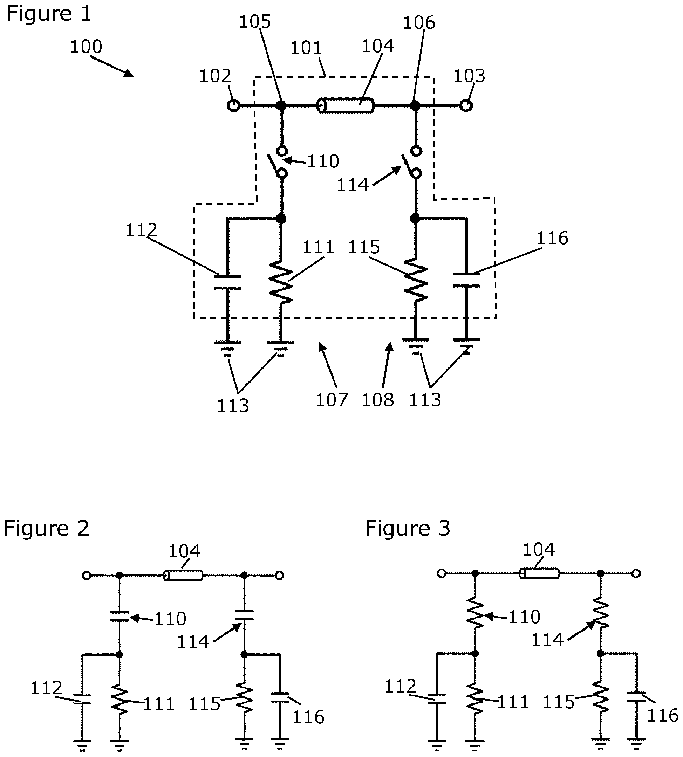

Example figure 1 shows a circuit 100 comprising a digital attenuator part 101. In the example of figure 1 the digital attenuator part 101 may be considered to comprise a digital step attenuator and, in particular, a one-bit digital step attenuator. In other examples, a plurality of digital attenuator parts 101 may be provided in series to thereby provide a multi-bit digital step attenuator. However, for simplicity, a one-bit implementation of the circuit 100 comprising a single attenuator part will be described.

The circuit 100 comprises a first attenuator terminal 102, which may comprise an input terminal for a signal to be selectively attenuated. The circuit 100 further comprises a second attenuator terminal 103, which may comprise an output terminal for the selectively attenuated signal provided at the input terminal. It will be appreciated that the input and output terminals may be reversed as this example implementation is not unidirectional.

The attenuator part 101 comprises a first inductor 104 having a first terminal 105 coupled to the first attenuator terminal 102 and a second terminal 106 coupled to the second attenuator terminal 103. In this and one or more examples, the first inductor 104 comprises a quarter-wave impedance transformer with respect to an operating frequency of the circuit 100. Further, in one or more examples, the first inductor 104 is embodied as a quarter wavelength transmission line. In one or more examples, it will be appreciated that a transmission line may be embodied as a pi-network (e.g. C-L-C) or as one or more or two or more series-shunt networks (e.g. L-C-L-C-L-C...). Accordingly, the first inductor 104 may be embodied as a pi-network or as one or more series-shunt networks.

The attenuator part 101 comprises a first switched arrangement 107 and a second switched arrangement 108 coupled to opposite ends of the transmission line 104 (or to corresponding terminals 105, 106 of the inductor/pi network).

The first switched arrangement comprises a first switch 110 having a first switch-terminal and a second switch-terminal, wherein the first switch-terminal is coupled to the first terminal 105 of the first inductor 104. The first switched arrangement 107 further comprises a first resistor 111 and a first capacitor 112 arranged in parallel and coupled between the second switch-terminal and a reference terminal shown, in this example, as ground 113. However, it will be appreciated that the reference terminal may be configured to be coupled to any other reference voltage, as required.

Similarly, the second switched arrangement 108 comprises a second switch 114 having a first switch-terminal and a second switch-terminal, wherein the first switch-terminal is coupled to the second terminal 106 of the first inductor 104. The second switched arrangement 108 further comprises a second resistor 115 and a second capacitor 116 arranged in parallel and coupled between the second switch-terminal and ground 113.

In the one or more examples the first resistor 111 has the same resistance as the second resistor 115. However, in other examples, the resistances may differ. Further, in this and one or more other examples, the first capacitor 112 has the same capacitance as the second capacitor 116. However, in other examples, the capacitances may differ.

The first and second switches 110, 114 may be implemented as transistors in one or more examples.

Control of the first switch 110 and the second switch 114 provides the selective attenuation of the circuit 100. Thus, the digital step attenuator part 101 may be configured to provide an attenuation mode in which a signal provided at the first terminal 102 and output at second terminal 103 would be attenuated. Further the digital step attenuator part 101 may be configured to provide a bypass mode in which the attenuation is not provided and the signal provided at the input passes through the transmission line 104 and is output at the second terminal 103 without the attenuation.

In the attenuation mode both the first switch 110 and the second switch 114 are closed (i.e. on) to thereby provide the attenuation. In the bypass mode both the first switch 110 and the second switch 114 are open (i.e. off).

When the first switch 110 and the second switch 114 are in the off state, the switches present a parasitic capacitance $C_{off}$, as shown in figure 2 which replaces the switches with symbolic capacitors. This capacitance introduces a capacitive load impedance in parallel with the quarter wavelength transmission line 104. In attenuation mode, if the first capacitor 112 and the second capacitor 116 were not present, the first and second switched arrangements 107, 108 would present only a resistive load, comprising the on-resistance of the switches 110, 114 and the resistance of the first resistor 111 and the second resistor 115. The effective circuit with the switches in the on state is shown in Figure 3 which replaces the switches with symbolic resistors. Without wishing to be bound by theory, it is thought that this difference in the capacitive loading and pure resistive loading between bypass and attenuation mode is the cause of much of the Gain-to-Phase error. However, as shown in figure 1, the present example includes the first capacitor 112 and the second capacitor 116 such that in the attenuation mode, with the first switch 110 and the second switch 114 in the on state, the first capacitor 112 and the second capacitor 116 provide a capacitance similar to the bypass mode. Providing a circuit that presents this capacitance in both the attenuation mode and the bypass mode may, in one or more examples, provide for a reduction in the gain-to-phase error of the attenuator part 101.

Further, the capacitance of the first capacitor 112 and the second capacitor 116 may be configured to achieve the same capacitive loading and the same phase shifting between the bypass and attenuation modes, which may mean a zero Gian-to-Phase error at an operating (e.g. center) frequency of the circuit 100. In other examples, some gain-to-phase error may be acceptable and therefore the capacitance of the first capacitor 112 and the second capacitor 116 may be configured such that the capacitive loading and/or the phase shifting introduced by the first and second switched arrangements 107, 108 between the bypass and attenuation modes is within a predetermined threshold.

As an example, the first inductor or transmission line 104 may have an impedance of 53 Ohms. The off-state capacitance of the first switch 110 and the second switch 114 may comprise 5 femtofarads. The resistance of the first and second resistors 111, 115 may comprise 71 Ohms. The capacitance of the first capacitor 112 and the second capacitor 116 may comprise 12 femtofarads. Thus, in one or more examples, the capacitance of the first capacitor 112 and the second capacitor 116 may be greater than the parasitic off state capacitance of the first switch 110 and the second switch 114.

In one or more examples, the resistance, $R_{att}$, of the first and second resistors 111, 115 may comprise:

$$R_{att} > \frac{2\omega C_{off} R_{on}{}^2}{1 - 2\omega C_{off} R_{on}}$$

wherein Ron comprises the on-state resistance of the first switch 110 and the second switch 114 and ω represents angular frequency representing the operating frequency of the circuit 100. Thus, given a specific switch 110, 112 having a characteristic Ron and Coff, and an operational frequency (w), the equation provides the minimum value of Ratt, which sets up the maximum attenuation ratio of the attenuation.

In one or more examples, the capacitance,

$C_{ATT}$, of the first capacitor 112 and the second capacitor 116 is broadly defined by:

$$C_{off} < C_{att} < \frac{R_{att} + R_{on}}{\omega R_{att} R_{on}}$$

In more general terms and in one or more examples, $C_{att}$ may be greater than Coff.

In one or more examples, an estimated solution for $C_{att}$ is:

$$C_{att} \approx C_{off} \left(1 + \frac{R_{on}}{R_{att}}\right)^2$$

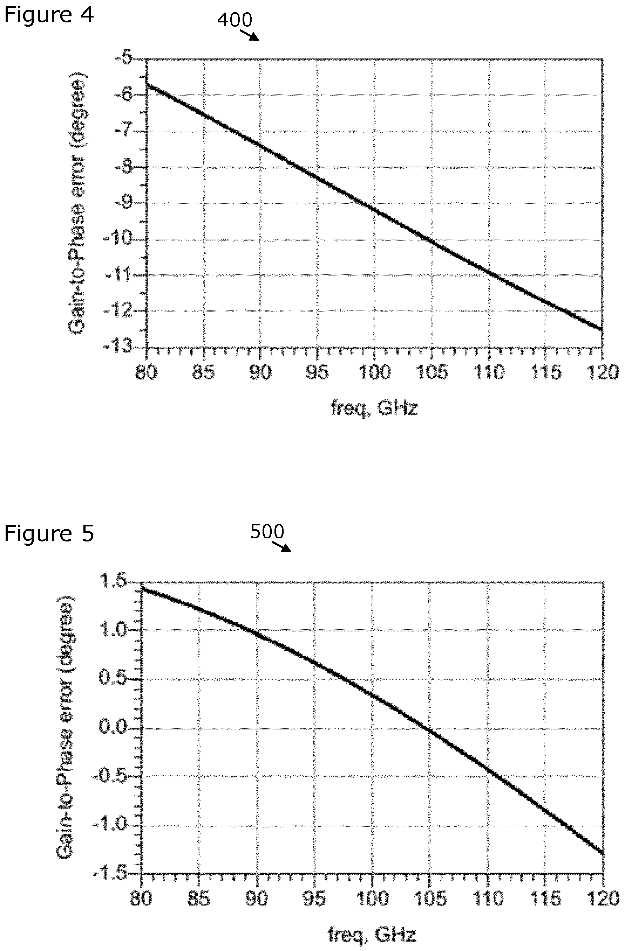

Figures 4 and 5 show simulated performance of different implementations of a one bit 4-dB Digital Step Attenuator. The y-axis shows Gain-to-Phase error, wherein Gain-to-Phase error is defined as bypass mode S21 phase (in degrees) minus attenuation mode S21 phase (in degrees).

Figure 4 shows a graph of the gain-to-phase error versus frequency of a signal provided to a known attenuator that does not include the first capacitor 112 nor second capacitor 116. The known attenuator is configured to provide an attenuation step of 4-dB. It will be appreciated that there is a significant change in gain-to-phase error with frequency as well as deviating from zero significantly. Figure 5 shows an example graph of gain-to-phase error versus frequency of a signal provided to the circuit 100 of figure 1, which is also configured to provide an attenuation step of 4-dB. The scale of the y-axis showing gain-to-phase error is different to figure 4 and shows a flatter or more stable gain-to-phase error with frequency as well as a gain-to-phase error close to zero over a predetermined range of frequencies around the centre operating frequency of the circuit.

As mentioned above the circuit 100 may be configured as a multi-bit attenuator (not shown) and may therefore comprise a first attenuator part 101 and be provided in combination with at least a second attenuator part. The second attenuator part has the same construction as first attenuator part 101, and has its first (input) terminal 102 coupled to the output terminal 103 of the first attenuator part 101.

Analog Front End Implementation

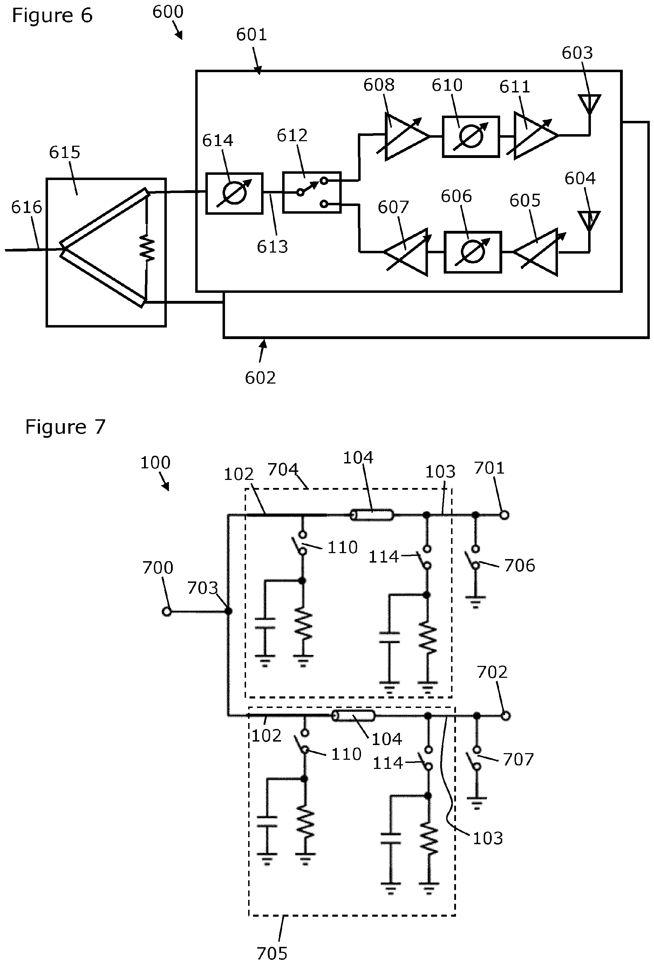

Example Figure 6 shows a typical implementation of an analog front end of a transmitter/receiver, which may comprise an analog beamformer for millimetre wave operation.

Figure 6 shows a typical block diagram of 2-channel analog beamformer 600. The device comprises two channels comprising a first channel 601 and a second channel 602, although other numbers of channels may be provided. Each channel 601, 602 may comprise a transmit path and/or a receive path that is couplable to a respective transmit antenna 603 and a receive antenna 604. In other examples, the antenna may be shared. The receive path comprises amplifier 605, a phase shifter 606, and a further amplifier 607. The transmit path comprises amplifier 608, phase shifter 610 and further amplifier 611. The amplifiers 605, 607, 608 and 611 may comprise amplifiers with gain control (for example, they may be Variable Gain Amplifiers or multi-stage amplifiers cascading with DSA). In other examples, the transmit path and the receive path may comprise other components such as at least one amplifier. The device may comprise a TX/RX switch 612 which is configured to select either the transmit path or the receive path for a common terminal 613. A typical implementation of the TX/RX switch 612 is a quarter wavelength switch.

The common terminal 613 may be coupled to a common-leg phase shifter 614 for the channel 601 serving for both the transmit and receive paths. A Wilkinson power splitter/combiner 615 may be provided to split (or combine) the transmit power of the signal from a further common node 616 to the first channel 601 and second channel 602 (or combine the power from the first channel 601 and the second channel 602 towards the common node 616).

Similar to the attenuator part 101 described above, the switch 612 includes at least one quarter wavelength transmission line, although the quarter wavelength transmission line may be embodied as a pi-network (e.g. C-L-C) in other examples. The analog front end 600 thus uses a switch having a quarter wavelength transmission line and may also require the functionality of the attenuator part 101. A quarter wavelength transmission line occupies significant chip area. Hence, instead of cascading the quarter wavelength transmission line based digital step attenuator 101 with other blocks, the following example embodiment combines the functionality of the switch 612 and the attenuator part 101 to provide a space efficient selectively attenuating switch.

In such an embodiment, shown in Figure 7, the circuit 100 comprises a plurality of said digital attenuator parts 101 as shown in Figure 1. The digital attenuator parts are integrated with a switch part.

The switch part comprises a common terminal 700, a first switch-part terminal 701 and a second switch-part terminal 702. The switch part is switchable at least between providing a first path for a signal between the common terminal 700 and the first switch-part terminal 701 and providing a second, different path for a signal between the common terminal 700 and the second switch-part terminal 702. In the present example, the switch part is configured to provide switching for an alternating signal and therefore the control of the impedance of each path defines the route available for the signal rather than by breaking and forming of physical connections.

The common terminal 700, if the circuit 100 was implemented in the analog front end 600, would comprise common terminal 613. Likewise, the first switch-part terminal 701 may provide the connection to the transmit path and the second switch-part terminal 702 may provide the connection to the receive path.

The switch part comprises at least one branch point 703 wherein the circuit 100 branches from the common terminal 700 to the first switch-part terminal 701 by a first branch and from the common terminal 700 to the second switch-part terminal 702 by a second branch. It will be appreciated that further branches may be provided.

A first digital attenuator part 704, in the present example, has the same form as the attenuator part 101 of figure 1. The first digital attenuator part 704, in this example, is arranged in the first branch. A second digital attenuator part 705, in the present example, has the same form as the attenuator part 101 of figure 1. The second digital attenuator part 705, in this example, is arranged in the second branch.

Thus, the first digital attenuator part 704 is configured with its first attenuator terminal 102 connected to the common terminal 700 (via branch point 703 in this example) and its second attenuator terminal 103 is connected to the first switch-part terminal 701. Likewise, the second digital attenuator part 705 is configured with its first attenuator terminal 102 connected to the common terminal 700 (via branch point 703 in this example) and its second attenuator terminal 103 connected to the second switch-part terminal 702.

Each of the plurality of said digital attenuator parts 704, 705 are configured to provide an attenuation mode in which both the first switch 110 and the second switch 114 of the respective attenuator part are closed to thereby provide attenuation of a signal and a bypass mode in which both the first switch 110 and the second switch 114 of the respective attenuator part 704, 705 are open.

In one or more examples, the switch part comprises a third switch 706 coupled to the first switch-part terminal 701 and configured to provide a switched connection to the ground terminal (or other reference voltage). The switch part also comprises a fourth switch 707 coupled to the second switch-part terminal 702 and configured to provide a switched connection to the ground terminal (or other reference voltage).

The third switch 706 and fourth switch 707 effectively block and permit a signal to pass to/from the respective terminals 701, 702 based on their switch state. It will be appreciated in other examples a different means of switching may be provided, such as by a transistor or other switch type controlling the connection to the respective branches.

Thus, the switch part may be considered to comprise the terminals 700, 701, 702; the third and fourth switches 706, 707; the branches from branch point 703; and, in part, the quarter wavelength transmission lines 104 of each of digital attenuator parts 704, 705. It will be appreciated that the quarter wavelength transmission lines 104 of each of digital attenuator parts 704, 705 are shared with the switch part, which saves chip area.

Thus, the first and second digital attenuator parts 704, 705 and the switch part in combination are configured to provide four modes of operation. The modes comprise providing a signal path to/from the first switch-part terminal 701, providing a signal path to/from the second switch-part terminal 702, and selectively providing attenuation in each of those switch states.

Thus, a first-attenuator-terminal-with-attenuation mode is provided with the third switch 706 off (open) and the fourth switch 707 on (closed) to provide the path for the signal between the common terminal 700 and the first switch-part terminal 701. The closing of the fourth switch 707 is configured to effectively block the path to/from the second switch-part terminal 702. The first switch 110 and the second switch 114 of the first digital attenuator part 704 are on to provide the attenuation. Thus, an attenuated signal path is provided between the common terminal 700 and the first switch-part terminal 701. In this mode, the first switch 110 and the second switch 114 of the second digital attenuator part 705 may also be on or off. It will be appreciated by those skilled in the art that closing the fourth switch 707 causes the quarter wavelength transmission line 104 of part 704 to transform the impedance from "short" (low-Ohmic) termination at node 103 of part 705 to "open" (high-Ohmic) termination at terminal 102 of part 705. Due to the "open" termination at terminal 102 of 705, the signal from common terminal 700 will not leak to the branch leading to the part 705 and instead travel through the branch leading to part 704 and onward to the first switch-part terminal 701.

A first-attenuator-terminal-without-attenuation mode is provided in which the third switch 706 is off and the fourth switch 707 is on to provide the path for the signal between the common terminal 700 and the first switch-part terminal 701. The closing of the fourth switch 707 is configured to effectively block the path to/from the second switch-part terminal 702 for a signal. The first switch 110 and the second switch 114 of the first digital attenuator part 704 are off to not provide the attenuation. Thus, a non-attenuated signal path is provided between the common terminal 700 and the first switch-part terminal 701. In this mode, the first switch 110 of the second digital attenuator part 705 is off and the second switch 114 of the second digital attenuator part 705 may be on or off.

A second-attenuator-terminal-with-attenuation mode is provided with the third switch 706 on (closed) and the fourth switch 707 off (open) to provide the path for the signal between the common terminal 700 and the second switch-part terminal 702. The closing of the third switch 706 is configured to effectively block the path to/from the first switch-part terminal 701. The first switch 110 and the second switch 114 of the second digital attenuator part 705 are on to provide the attenuation. Thus, an attenuated signal path is provided between the common terminal 700 and the second switch-part terminal 702. In this mode, the first switch 110 and the second switch 114 of the first digital attenuator part 704 may also be on or off.

A second-attenuator-terminal-without-attenuation mode is provided in which the third switch 706 is on and the fourth switch 707 is off to provide the path for the signal between the common terminal 700 and the second switch-part terminal 702. The closing of the third switch 706 is configured to effectively block the path to the first switch-part terminal 701. The first switch 110 and the second switch 114 of the second digital attenuator part 705 are off to not provide the attenuation. Thus, a non-attenuated signal path is provided between the common terminal 700 and the second switch-part terminal 702. In this mode, the first switch 110 of the first digital attenuator part 704 is off and the second switch 114 of the first digital attenuator part 704 may be on or off.

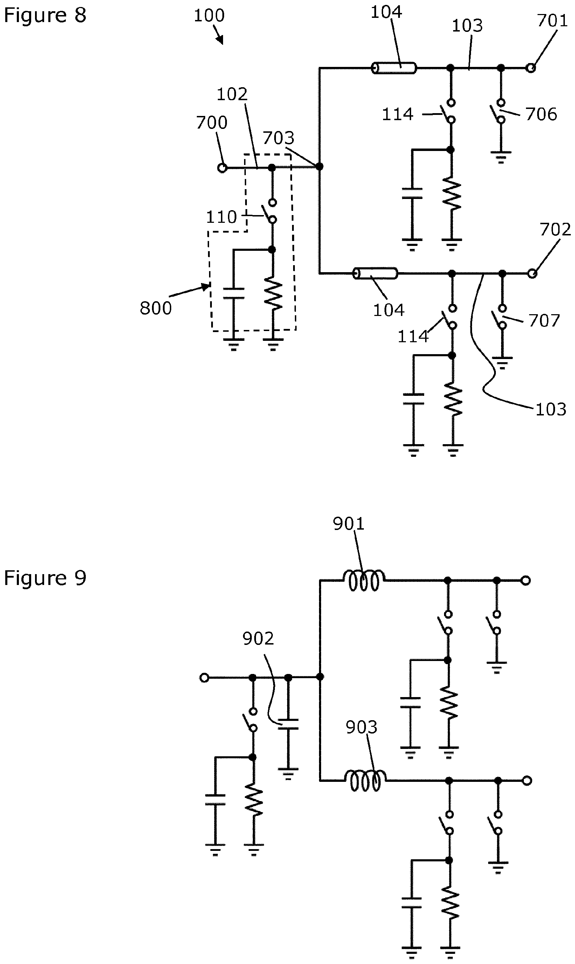

Figure 8 shows a second example embodiment based on the structure of Figure 7 and therefore only the difference will be described. In this example, the first switched arrangement 107 (see figure 1) of the first digital attenuator part 704 and the first switched arrangement 107 of the second digital attenuator part 705 comprise a shared first switched arrangement 800 for both the first digital attenuator part and the second digital attenuator part. Thus, the shared first switched arrangement 800 is arranged between the common terminal 700 and the branch node 703 and serves as the first switched arrangement 107 for the first and second digital attenuator parts 704, 705 (shown in figure 7).

In the first-attenuator-terminal-with-attenuation mode, the first switch 110 of the shared first switched arrangement 800 is on (closed).

In the first-attenuator-terminal-without-attenuation mode the first switch 110 of the shared first switched arrangement 800 is off (open).

In the second-attenuator-terminal-with-attenuation mode the first switch 110 of the shared first switched arrangement 800 is on (closed).

In the second-attenuator-terminal-without-attenuation mode the first switch 110 of the shared first switched arrangement 800 is off (open).

Figure 9 shows a further embodiment that comprises a variation of the embodiment of Figure 8 and therefore only the difference will be described.

In the example Figure 9, the quarter wavelength transmission lines 104 of each branch are replaced with a low pass pi-network arrangement. The pi-network arrangement comprises, for the first branch, the lumped inductance 901 in combination with the LC-capacitor 902. The pi-network arrangement comprises, for the second branch, the lumped inductance 903 in combination with the same LC-capacitor 902.

The other components of the example embodiment of Figure 9 are the same as Figures 7 and 8 and will not be described further. It will be appreciated that the LC networks of figure 9 may be provided in the arrangement of Figure 7.

In the examples herein the attenuation between the paths is symmetrical. However, in other examples asymmetric attenuation may be provided by configuring at least the second capacitor and/or second resistor to have different values in the second switched arrangement 108 of the respective digital step attenuators 704, 705.

As mentioned previously, the circuit 100 shown in Figures 7 to 9 may comprise a TX/RX switch. However it will be appreciated that the circuit 100 may be considered more generally as a switch to switch between two or more different branches and to provide selective attenuation in one or more of those branches. However, in the TX/RX switch implementation, the first switch-part terminal 701 may be coupled to a transmit path wherein the switch part is configured to switchably couple the common terminal 700 to the first switch-part terminal 701 to enable a signal provided at the common terminal to be transmitted. The impedance of the second path effectively blocks the receive path. As mentioned above in the description of figure 7 and of the modes of operation, the transmission lines 104, 901, 903 in combination with the switch positions provide the impedance inverting characteristics to achieve the operation. Further, the second switch-part terminal 702 is coupled to a receive path wherein the switch part is configured to switchably couple the common terminal 700 to the second switch-part terminal 702 to enable a signal to be received from the receive path and passed to the common terminal 700. The impedance of the first path effectively blocks the transmit path. Again, the transmission lines 104, 901, 903 in combination with the switch positions provide the impedance inverting characteristics to achieve the operation.

In one or more examples, the circuit 100, in any of the embodiments of Figures 7-9, may be operated in a standby mode.

When the circuit 100 is provided as a combination of a switch part and attenuator part, such as in an analog beamformer as shown in Figure 6, and is applied in user equipment (UE) rather than a base station, the standby mode may be advantageous. In particular, when the UE is too close to base station, the receive path antenna(s) may receive too much input power and in such a situation the system may be configured to shut down part of the receiver channels to limit the received signal level. However, with reference to Figure 6 as an example, perhaps we want to turn off the first channel 601 (i.e. transmit and receive paths), and only turn on the receive path for the second channel 602. In order to keep the Wilkinson power combiner 615 working properly, although the first channel 601 is turned off, the first channel common terminal 613 still needs to provide a well-defined input impedance with a return loss typically better than -10 dB, for example. This may be where the standby mode may be useful.

For the channel 601, 602 standby mode, we can use this circuit of figures 7-9 to provide a well-defined interface impedance. In conventional devices, amplifier input and output impedance changes significantly between on and off state. Thus, the standby mode comprises configuring the third switch 706, fourth switch 707, second switch 114 of the first digital attenuator part 704 and second switch 114 of the second digital attenuator part 705 to the on state (closed). This will eliminate the impact of amplifier impedance variation. Since the quarter wavelength lines 104, 901 of the first and second digital attenuator parts 704, 705 transforms the short (low-Ohmic) termination provided by the third switch 706 and the fourth switch 707 to open (high-Ohmic) termination, the common terminal 700 sees an undesired very high-Ohmic interface. Hence we turn on the first switch 110 (of the shared 800 or individual first and second digital attenuator parts 704, 705) and use the attenuation parts to decrease the channel common-leg input impedance to a value similar to that provided in the receive mode.

In summary, for the standby mode (with turned-off transmit and receive paths), all the switches 110, 114, 706, 707 are all turned on to provide a well-defined impedance and good return loss at the input terminal 700.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A circuit comprising:
   a digital attenuator part comprising:

   a first attenuator terminal;
   a second attenuator terminal;
   a first inductor having a first terminal coupled to the first attenuator terminal and a second terminal coupled to the second attenuator terminal;
   a first switched arrangement comprising a first switch having a first switch-terminal and a second switch-terminal, wherein the first switch-terminal is coupled to the first terminal of the first inductor, and wherein a first resistor and a first capacitor are arranged in parallel and coupled between the second switch-terminal and a reference terminal, the reference terminal configured to be coupled to a reference voltage;
   a second switched arrangement comprising a second switch having a first switch-terminal and a second switch-terminal, wherein the first switch-terminal is coupled to the second terminal of the first inductor, and wherein a second resistor and a second capacitor are arranged in parallel and coupled between the second switch-terminal and the reference terminal.

**2.** The circuit of claim 1, wherein the first inductor comprises a quarter-wave impedance transformer and is embodied as one of:

a quarter wavelength transmission line; and a pi-network.

**3.** The circuit of claim 1 or claim 2, wherein one or both of:

the first resistor has the same resistance as the second resistor; and the first capacitor has the same capacitance as the second capacitor.

**4.** The circuit of any preceding claim, wherein the digital step attenuator part is configured to provide:

an attenuation mode in which both the first switch and the second switch are closed to thereby provide attenuation of a signal input to the first attenuator terminal and output at the second attenuator terminal; and a bypass mode in which both the first switch and the second switch are open.

**5.** The circuit of any preceding claim, wherein the capacitance of one or both of the first capacitor and the second capacitor is greater than the off-state capacitance of one or both the first switch and the second switch.

**6.** The circuit of any preceding claim, wherein the circuit comprises a plurality of said digital attenuator parts coupled together in series by their first and second attenuator terminals to provide a multi-bit digital step attenuator.

**7.** The circuit of any preceding claim, comprising a plurality of said digital attenuator parts and further comprising a switch part, the switch part comprising:

a common terminal, a first switch-part terminal and a second switch-part terminal, wherein the switch part is switchable at least between providing a path for a signal between the common terminal and the first switch-part terminal and providing a path for a signal between the common terminal and the second switch-part terminal; wherein a first digital attenuator part of said plurality of digital attenuator parts is configured with its first attenuator terminal connected to the common terminal and its second attenuator terminal connected to the first switch-part terminal; and a second digital attenuator part of said plurality of digital attenuator parts is configured with its first attenuator terminal connected to the common terminal and its second attenuator terminal connected to the second switch-part terminal; and wherein

each of the plurality of said digital attenuator parts are configured to provide an attenuation mode in which both the first switch and the second switch of the respective attenuator part are closed to thereby provide attenuation of a signal and a bypass mode in which both the first switch and the second switch of the respective attenuator part are open.

**8.** The circuit of claim 7, wherein

the switch part comprises a third switch coupled to the first switch-part terminal and configured to provide a switched connection to the ground terminal; and the switch part comprises a fourth switch coupled to the second switch-part terminal and configured to provide a switched connection to the ground terminal.

**9.** The circuit of claim 8, wherein the first and second digital attenuator parts and the switch part in combination are configured to provide four modes, wherein the modes comprise:

a first-attenuator-terminal-with-attenuation mode in which the third switch is off, the fourth switch is on and the second switch of the second digital attenuator part is on to provide the path for the signal between the common terminal and the first switch-part terminal, and wherein the first switch and the second switch of the first digital attenuator part is on to provide the attenuation; a first-attenuator-terminal-without-attenuation mode in which the third switch is off, the fourth switch is on and the second switch of the second digital attenuator part is on to provide the path for the signal between the common terminal and the first switch-part terminal, and wherein the first switch and the second switch of the first digital attenuator part is off to not provide the attenuation; a second-attenuator-terminal-with-attenuation mode in which the third switch is on, the fourth switch is off and the second switch of the first digital attenuator part is on to provide the path for the signal between the common terminal and the second switch-part terminal, and wherein the first switch and the second switch of the second digital attenuator part is on to provide the attenuation;

a second-attenuator-terminal-without-attenuation mode in which the third switch is on, the fourth switch is off and the second switch of the first digital attenuator part is on to provide the path for the signal between the common terminal and the second switch-part terminal, and wherein the first switch and the second switch of the second digital attenuator part is off to not provide the attenuation.

10. The circuit of claim 7 or claim 8, wherein the first switched arrangement of the first digital attenuator part and the first switched arrangement of the second digital attenuator part comprise a shared first switched arrangement for both the first digital attenuator part and the second digital attenuator part.

11. The circuit of claim 10, wherein the switch part includes a first branch between the shared first switched arrangement and the first inductor of the first digital attenuator part and a second branch between the shared first switched arrangement and the first inductor of the second digital attenuator part.

12. The circuit of any one of claims 7 to 11, wherein at least one of the first inductor of the first digital attenuator part and the first inductor of the second digital attenuator part comprise a quarter wavelength transmission line.

13. The circuit of any one of claims 7 to 11, wherein at least one of the first inductor of the first digital attenuator part and the first inductor of the second digital attenuator part comprise part of a pi-network arrangement.

14. The circuit of any one of claims 7 to 13, wherein

said first switch-part terminal is coupled to a transmit path wherein the switch part is configured to switchably couple the common terminal to the first switch-part terminal to enable a signal provided at the common terminal to be transmitted; and

said second switch-part terminal is coupled to a receive path wherein the switch part is configured to switchably couple the common terminal to the second switch-part terminal to enable a signal to be received from the receive path and passed to the common terminal.

15. The circuit of any one of claims 7 to 14, wherein the plurality of said digital attenuator parts and the switch part collectively provide a quarter wave TX/RX switch having selectively provided attenuation.

**Amended claims in accordance with Rule 137(2) EPC.**

1. A circuit (100) comprising:

a plurality of digital attenuator parts (101), wherein each of the plurality of digital attenuator parts comprises:

a first attenuator terminal (102);
a second attenuator terminal (103);
a first inductor (104) having a first terminal (105) coupled to the first attenuator terminal and a second terminal (106) coupled to the second attenuator terminal;
a first switched arrangement (107) comprising a first switch (110) having a first switch-terminal and a second switch-terminal, wherein the first switch-terminal is coupled to the first terminal (105) of the first inductor (104), and wherein a first resistor (111) and a first capacitor (112) are arranged in parallel and coupled between the second switch-terminal and a reference terminal (113), the reference terminal configured to be coupled to a reference voltage;
a second switched arrangement (108) comprising a second switch (114) having a first switch-terminal and a second switch-terminal, wherein the first switch-terminal is coupled to the second terminal (106) of the first inductor (104), and wherein a second resistor (115) and a second capacitor (116) are arranged in parallel and coupled between the second switch-terminal and the reference terminal (113), the circuit further comprising a switch part, the switch part comprising:

a common terminal (700), a first switch-part terminal (701) and a second switch-part terminal (702), wherein the switch part is switchable at least between providing a path for a signal between the common terminal (700) and the first switch-part terminal (701) and providing a path for a signal between the common terminal (700) and the second switch-part terminal (702); wherein a first digital attenuator part (704) of said plurality of digital attenuator parts (101) is configured with its first attenuator terminal (102) connected to the common terminal (700) and its second attenuator terminal (103) connected to the first switch-part terminal (701); and
a second digital attenuator part (705) of said plurality of digital attenuator parts (101) is configured with its first attenuator terminal (102) connected to the common terminal (700) and its second attenuator terminal (103) connected to the second switch-part terminal (702); and wherein each of the plurality of said digital attenuator parts (101) are configured to provide an attenuation mode in which both the first switch (110) and the second switch (114) of the respective attenuator part are closed to thereby provide attenuation of a signal and a bypass mode in which both the first switch (110) and the second switch (114) of the respective attenuator part (704, 705) are open.

2. The circuit (100) of claim 1, wherein the first inductor (104) comprises a quarter-wave impedance transformer embodied as one of:

a quarter wavelength transmission line; and a pi-network.

3. The circuit (100) of claim 1 or claim 2, wherein one or both of:

the first resistor (111) has the same resistance as the second resistor (115); and the first capacitor (112) has the same capacitance as the second capacitor (116).

4. The circuit (100) of any preceding claim, wherein the digital attenuator part (101) is configured to provide:

an attenuation mode in which both the first switch (110) and the second switch (114) are closed to thereby provide attenuation of a signal input to the first attenuator terminal (102) and output at the second attenuator terminal (103); and a bypass mode in which both the first switch (110) and the second switch (114) are open.

5. The circuit (100) of any preceding claim, wherein the capacitance of one or both of the first capacitor (112) and the second capacitor (116) is greater than the off-state capacitance of one or both the first switch (110) and the second switch (114).

6. The circuit (100) of any preceding claim, wherein the circuit comprises a plurality of said digital attenuator parts (101) coupled together in series by their first and second attenuator terminals (102, 103) to provide a multi-bit digital step attenuator.

7. The circuit (100) of any preceding claim, wherein

the switch part comprises a third switch (706) coupled to the first switch-part terminal (701) and configured to provide a switched connection to the ground terminal; and the switch part comprises a fourth switch (707)

coupled to the second switch-part terminal (702) and configured to provide a switched connection to the ground terminal.

8. The circuit (100) of claim 7, wherein the first and second digital attenuator parts (704, 705) and the switch part in combination are configured to provide four modes, wherein the modes comprise:

a first-attenuator-terminal-with-attenuation mode in which the third switch (706) is off, the fourth switch (707) is on and the second switch (114) of the second digital attenuator part (705) is on to provide the path for the signal between the common terminal (700) and the first switch-part terminal (701), and wherein the first switch (110) and the second switch (114) of the first digital attenuator part (704) is on to provide the attenuation;
a first-attenuator-terminal-without-attenuation mode in which the third switch(706) is off, the fourth switch (707) is on and the second switch (114) of the second digital attenuator part (705) is on to provide the path for the signal between the common terminal (700) and the first switch-part terminal (701), and wherein the first switch (110) and the second switch (114) of the first digital attenuator part (704) is off to not provide the attenuation;
a second-attenuator-terminal-with-attenuation mode in which the third switch (706) is on, the fourth switch (707) is off and the second switch (114) of the first digital attenuator part (704) is on to provide the path for the signal between the common terminal (700) and the second switch-part terminal (702), and wherein the first switch (110) and the second switch (114) of the second digital attenuator part (705) is on to provide the attenuation;
a second-attenuator-terminal-without-attenuation mode in which the third switch (706) is on, the fourth switch (707) is off and the second switch (114) of the first digital attenuator part (704) is on to provide the path for the signal between the common terminal (700) and the second switch-part terminal (702), and wherein the first switch (110) and the second switch (114) of the second digital attenuator part (705) is off to not provide the attenuation.

9. The circuit (100) of any of claims 1 to 7, wherein the first switched arrangement (107) of the first digital attenuator part (704) and the first switched arrangement (107) of the second digital attenuator part (705) consist of a single shared first switched arrangement (800) for both the first digital attenuator part (704) and the second digital attenuator part (705).

**10.** The circuit (100) of claim 9, wherein the switch part includes a first branch between the shared first switched arrangement (800) and the first inductor (104) of the first digital attenuator part (704) and a second branch between the shared first switched arrangement (800) and the first inductor (104) of the second digital attenuator part (705).

**11.** The circuit (100) of any one of any preceding claim, wherein at least one of the first inductor (104) of the first digital attenuator part (704) and the first inductor (104) of the second digital attenuator part (705) comprise a quarter wavelength transmission line.

**12.** The circuit (100) of any one of claims 1 to 10, wherein at least one of the first inductor of the first digital attenuator part and the first inductor of the second digital attenuator part comprise part of a pi-network arrangement.

**13.** The circuit (100) of any one of any preceding claim, wherein

said first switch-part terminal (701) is coupled to a transmit path wherein the switch part is configured to switchably couple the common terminal (700) to the first switch-part terminal to enable a signal provided at the common terminal to be transmitted; and
said second switch-part terminal (702) is coupled to a receive path wherein the switch part is configured to switchably couple the common terminal (700) to the second switch-part terminal (702) to enable a signal to be received from the receive path and passed to the common terminal (700).

**14.** The circuit (100) of any one of any preceding claim, wherein the plurality of said digital attenuator parts (101) and the switch part collectively provide a quarter wave TX/RX switch having selectively provided attenuation.

**Figure 1**

**Figure 2**

**Figure 3**

Figure 4

Figure 5

## Figure 6

## Figure 7

Figure 8

Figure 9

Europäisches
Patentamt

European
Patent Office

Office européen
des brevets

# EUROPEAN SEARCH REPORT

**Application Number**

EP 22 19 6939

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2016 208220 A (MITSUBISHI ELECTRIC CORP) 8 December 2016 (2016-12-08) | 1-6 | INV. H03H7/25 H03H7/46 H01P1/22 H04B1/44 |
| Y | * paragraphs [0016], [0020], [0024]; figure 7 * | 7-15 | |
| X | CN 107 707 218 A (ZENG CHUANDE) 16 February 2018 (2018-02-16) | 1,3-6 | |
| Y | * paragraph [0021]; figures 5,6 * | 7-11,14, 15 | |
| Y | US 2003/132814 A1 (NYBERG PETRI [FI]) 17 July 2003 (2003-07-17) * paragraphs [0030] - [0034], [0038]; figures 3,4A,5,7B * | 1-15 | |
| Y | JP H07 312508 A (MITSUBISHI ELECTRIC CORP) 28 November 1995 (1995-11-28) * paragraph [0020]; figures 1,3,5 * | 1-15 | |
| Y | US 2018/062621 A1 (YAN YAN [US] ET AL) 1 March 2018 (2018-03-01) * paragraph [0010]; figures 3,11,12 * | 1-15 | TECHNICAL FIELDS SEARCHED (IPC) |
| Y | LI NAYU ET AL: "A DC-28-GHz 7-Bit High-Accuracy Digital-Step Attenuator in 55-nm CMOS", IEEE MICROWAVE AND WIRELESS COMPONENTS LETTERS, IEEE SERVICE CENTER, NEW YORK, NY, US, vol. 32, no. 2, 29 October 2021 (2021-10-29), pages 157-160, XP011900292, ISSN: 1531-1309, DOI: 10.1109/LMWC.2021.3120934 [retrieved on 2022-02-10] * abstract; figures 1,2 * * section II * | 1-15 | H03H H04B H01P |

-/--

The present search report has been drawn up for all claims

| Place of search | Date of completion of the search | Examiner |
|---|---|---|
| Munich | 6 March 2023 | Maget, Judith |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 22 19 6939

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2016/150484 A1 (ERICSSON TELEFON AB L M [SE]) 29 September 2016 (2016-09-29) * page 1, line 4 - page 2, line 31; figures 1,2,4 * * page 4, lines 13-32 * | 1-15 | |
| Y | US 5 648 740 A (DEVLIN LIAM MICHAEL [GB] ET AL) 15 July 1997 (1997-07-15) * column 1, lines 5-60; figures 1,2 * * column 3, lines 32-47 * | 7-15 | |
| A | US 2011/273248 A1 (NICOLSON SEAN TIMOTHY [US] ET AL) 10 November 2011 (2011-11-10) * figure 3 * | 8-15 | |

TECHNICAL FIELDS
SEARCHED      (IPC)

The present search report has been drawn up for all claims

| Place of search | Date of completion of the search | Examiner |
|---|---|---|
| Munich | 6 March 2023 | Maget, Judith |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 19 6939

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2023

| Patent document cited in search report | | Publication date | Patent family member(s) | | Publication date |
|---|---|---|---|---|---|
| JP 2016208220 | A | 08-12-2016 | JP | 6425612 B2 | 21-11-2018 |
| | | | JP | 2016208220 A | 08-12-2016 |
| CN 107707218 | A | 16-02-2018 | NONE | | |
| US 2003132814 | A1 | 17-07-2003 | AU | 2003235655 A1 | 30-07-2003 |
| | | | EP | 1466382 A1 | 13-10-2004 |
| | | | JP | 2005525007 A | 18-08-2005 |
| | | | JP | 2008048455 A | 28-02-2008 |
| | | | KR | 20040075351 A | 27-08-2004 |
| | | | US | 2003132814 A1 | 17-07-2003 |
| | | | WO | 03061058 A1 | 24-07-2003 |
| JP H07312508 | A | 28-11-1995 | NONE | | |
| US 2018062621 | A1 | 01-03-2018 | CN | 109906554 A | 18-06-2019 |
| | | | DE | 112017004371 T5 | 16-05-2019 |
| | | | GB | 2568449 A | 15-05-2019 |
| | | | JP | 7069169 B2 | 17-05-2022 |
| | | | JP | 2019533400 A | 14-11-2019 |
| | | | JP | 2022110018 A | 28-07-2022 |
| | | | KR | 20190052011 A | 15-05-2019 |
| | | | SG | 11201901791T A | 28-03-2019 |
| | | | TW | 201813293 A | 01-04-2018 |
| | | | TW | 202234819 A | 01-09-2022 |
| | | | US | 2018062621 A1 | 01-03-2018 |
| | | | WO | 2018044798 A1 | 08-03-2018 |
| WO 2016150484 | A1 | 29-09-2016 | NONE | | |
| US 5648740 | A | 15-07-1997 | DE | 19540588 A1 | 09-05-1996 |
| | | | FR | 2726707 A1 | 10-05-1996 |
| | | | GB | 2294831 A | 08-05-1996 |
| | | | JP | H08256038 A | 01-10-1996 |
| | | | KR | 960019984 A | 17-06-1996 |
| | | | US | 5648740 A | 15-07-1997 |
| US 2011273248 | A1 | 10-11-2011 | CN | 102244504 A | 16-11-2011 |
| | | | EP | 2387151 A1 | 16-11-2011 |
| | | | JP | 5122613 B2 | 16-01-2013 |
| | | | JP | 2011239360 A | 24-11-2011 |
| | | | TW | 201145664 A | 16-12-2011 |
| | | | US | 2011273248 A1 | 10-11-2011 |

EPO FORM P0459

For more details about this annex : see Official Journal of the European Patent Office, No. 12/82